# EUROPEAN PATENT SPECIFICATION

(11) **EP 0 428 086 B1**
(45) Date of publication and mention of the grant of the patent: **02.11.1994**
(21) Application number: 90121518.6
(22) Date of filing: 09.11.1990
(51) Int. Cl.: H05K 3/42

(54) **Method of manufacturing a ceramic circuit board**
Verfahren zur Herstellung einer keramischen Schaltungsplatte
Méthode de la fabrication d'une plaque de circuit imprimé céramique

(30) Priority: 13.11.1989 JP 294228/89
(43) Date of publication of application: 22.05.1991
(73) Proprietor: SUMITOMO ELECTRIC INDUSTRIES, LTD., Osaka-shi, Osaka 541 (JP)
(72) Inventor: Yamakawa, Akira, c/o Itami Works, Itami-shi, Hyogo (JP); Osada, Mitsuo, c/o Itami Works, Itami-shi, Hyogo (JP); Ogasa, Nobuo, c/o Itami Works, Itami-shi, Hyogo (JP)
(74) Representative: Herrmann-Trentepohl, Werner, Dipl.-Ing.

(56) References cited:
- US-A- 4 684 446
- US-A- 4 861 641
- PATENT ABSTRACTS OF JAPAN vol. 13, no. 486 (E-840)(3834)6 November 1989 & JP-A-01 192 198

## Description

### Method of Manufacturing a Ceramic Circuit Board

### BACKGROUND OF THE INVENTION

### Field of the Invention

The present invention relates to a method of manufacturing a ceramic circuit board comprising a conductive portion capable of electrically connecting circuits formed on front and rear surfaces of an insulating board.

### Description of the Background Art

Recently, there have been increasingly strong demands for small sizes and high reliabilities of electronic devices. In order to meet such demands, methods of mounting integrated circuits have been developed from methods of mounting IC packages on print circuit boards as in the prior art to methods of patterning a conductor layer, resistors or the like mainly in a structure on a surface of an insulating board of ceramics for example, or directly mounting an IC chip on a board surface and hermetically sealing it.

In addition, according to demands for large scale integration or multiple functions of circuits, developments have been made to form circuit boards having circuits not only on the front surface of an insulating board but also on the rear surface thereof and including electrical connection of those circuits on the front and rear surfaces of the board by means of through-holes formed in the board.

In such a circuit board having circuits on both the front and rear surfaces of an insulating board, which are electrically connected, it is particularly required for the portions of through-holes formed in the board that:
a. the electrical connection between the circuits formed on the front and rear surfaces of the board be sufficiently ensured, and
b. a sufficient airtightness be maintained so as not to lose the airtightness by means of the through-holes in the case where the circuit formed on either surface of the board is hermetically sealed.

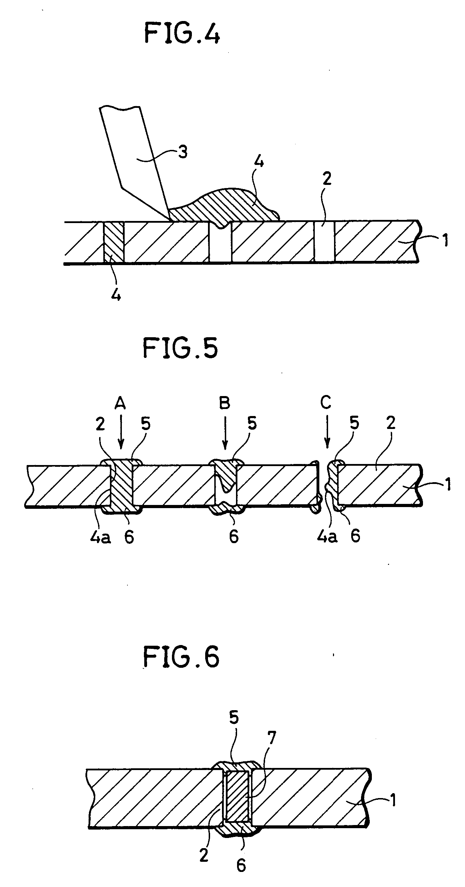

Conventionally, a method shown in Fig. 4 is used as a method for forming conductive portions in through-holes formed in a board. This method includes: forming prescribed through-holes 2 in an insulating board 1, squeezing metal paste 4 into the through-holes 2 using a rubber squeegee 3, and drying and sintering the metal paste in the through-holes 2, thereby forming metallic conductive portions in the through-holes 2. Then, as shown in A of Fig. 5, conductor patterns 5, 6 are formed on upper and lower surfaces of the conductive portions 4a filling the through-holes 2 of the insulating board 1, whereby the circuits on the front and rear surfaces of the insulating board 1 are electrically connected.

However, it is difficult to apply the above-mentioned method in a manner where the through-holes are completely filled as shown in A of Fig. 5, and defects as described below often occur. For example, as shown in B of Fig. 5, a gap is formed in a through-hole to cause defective connection between the conductor pattern 6 on the front surface of the board and the conductor pattern 6 on the rear surface thereof, or as shown in C of Fig. 5, the conductor pattern 5 on the front surface and the conductor pattern 6 on the rear surface of the board are connected by a conductive portion 4a which is slightly connected in the through-hole 2. Thus, this method cannot completely satisfy the above-mentioned requirements for the conductive portions 4a of the through-holes 2, namely, the requirement to ensure complete electric connection and the requirement to maintain airtightness.

Document US-4 861 641 discloses a ceramic composite wherein through-holes are formed by means of an infiltration method. For this infiltration method vias are punched in the green tape at desired locations and are filled with metal in. Afterwards, the ceramic substrate is co-fired to achieve a porosity layer in the vias. After co-firing, a nickel plating is applied to the substrate to ensure sufficient wetting of subsequently applied metal to the vias. Next, an infiltrating metal is applied to the co-fired substrate directly over the vias. Following the application of the infiltrating material, the composite piece is heated to melt the infiltrant. Porosity and small voids present in the vias are removed by means including displacement of the pore space by the molten infiltrant.

There is another method as shown in Fig 6. This method is disclosed in Japanese Patent Publication No. 63-64918. According to this method, at first, prescribed through-holes 2 are formed in an insulating board 1. Next, a conductor pattern 6 is formed on the rear surface of the board 1 to cover one opening of each through-hole 2. Then, a metallic wire 7 having a diameter slightly smaller than the inner diameter of each through-hole 2 and a length slightly shorter than the depth of each through-hole 2 is inserted into each through-hole 2 from the other open side. After that, a conductor pattern 5 is formed on the top of each metallic wire 7 to seal the other side of each through-hole 2.

However, this method also has a disadvantage in maintaining airtightness of the through-holes 2. More specifically, the airtightness is maintained only by the conductor patterns 5, 6 formed on the upper and lower openings of the through-holes 2 and a gap unavoidably exists between the corresponding metallic wire 7 and through-hole 2. Accordingly, if a small gap is formed in the work of making the conductor patterns 5, 6, the airtightness is lost thereby. In addition, it is difficult to automate the work of inserting the metallic wires 7 into the through-holes 2, and the efficiency of work is not good.

### SUMMARY OF THE INVENTION

An object of the present invention is to provide a method of manufacturing a ceramic circuit board including penetrating conductive portions having good electrical connection and airtightness, wherein, in particular, the conductive portions are filling tightly the through-holes in a ceramic circuit board.

The inventive method of manufacturing a ceramic circuit board to solve the above object is defined in claim 1.

The high-melting point metal layer is formed by sintering paste metal of a high melting point in each of the through holes formed in the insulating board. The high-melting point metal layer is formed in each through hole in a state containing gaps or voids. If a metal containing copper is melted to be in contact with such a high-melting point metal layer, the melted metal permeates into the high-melting point metal layer by a capillary phenomenon. Thus, conductive portions where gap regions of the high-melting point metal layer are tightly filled with copper or the like are formed. Those conductive portions filled with the high-melting point metal layer and the high-conductive material of copper or the like ensure a sufficient electric connection between the front and rear surfaces of the board. In addition, since the through-holes are tightly filled, airtightness between the front and rear surfaces of the board is ensured.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1A, 1B, 1C and 1D are views showing steps of manufacturing a ceramic circuit board according to an embodiment of the invention.

Fig. 2 is a view showing a variant of the manufacturing step shown in Fig. 1C.

Fig. 3 is a sectional structural view of an integrated circuit having a ceramic circuit board manufactured according to the present invention.

Fig. 4 is a view of a manufacturing step in a conventional method of forming conductive portions in a circuit board.

Fig. 5 is a sectional structural view of the circuit board formed by the method shown in Fig. 4.

Fig. 6 is a sectional structural view of a circuit board manufactured by another conventional method.

### DESCRIPTION OF THE PREFERRED EMBODIMENTS

An embodiment of the present invention will be described with reference to the drawings.

Referring first to Fig. 1A, a through-hole 2 is formed in a prescribed region of an insulating board 1. A board of aluminum nitride (AℓN), alumina (Aℓ₂O₃), beryllium oxide (BeO) or the like is used as the insulating board. Particularly, the board of aluminum nitride is preferred since it has an excellent heat radiating property and a low reactivity with copper and it is not attacked by permeation of copper in a subsequent step.

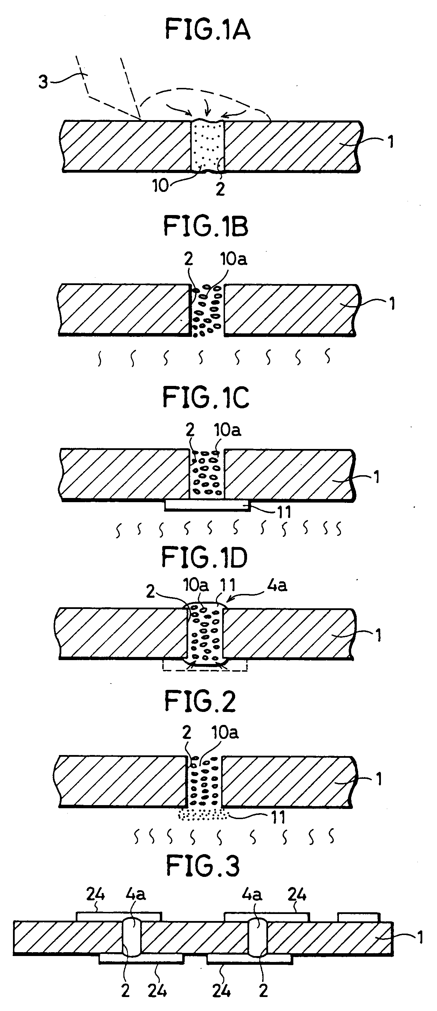

Next, the following two methods will be described as a method for forming a high-melting point metal layer in the through-hole. According to the first method, a perforation process is applied to a non-sintered AℓN sheet to form a through-hole 2 and thereafter tungsten (W) paste (conductive paste) 10 inserted into the through-hole 2 using a rubber squeegee 3. After that, the AℓN sheet 1 and the tungsten paste 10 are sintered at a high temperature of 1700°C or more in an atmosphere containing N₂, whereby a tungsten layer 10a is formed (as shown in Fig. 1B).

According to the second method, an AℓN board 1 sintered and including a prescribed through-hole 2 is prepared and tungsten or molybdenum (Mo) paste 10 is put into the through-hole 2 using a rubber squeegee 3. After that, the tungsten or molybdenum paste 10 is sintered in a non-oxidizing atmosphere, so that a tungsten or molybdenum layer 10a is formed (as shown in Fig. 1B).

The high-melting point metal layer 10a formed by such a method contains a large number of gaps because the solvent in the paste has been dissipated at the time of sintering. In addition, since it is difficult to sufficiently put the conductive paste in the through-hole 2, the through-hole 2 is formed to have some gaps without being completely filled.

Referring next to Fig. 1C, copper or copper alloy 11 is placed on the under side of the opening of the through-hole 2, so that it is heated and melted. This copper or copper alloy 11 may be of a plate type (as shown in Fig. 1C) or of a powder type as shown in Fig. 2. The heating temperature is 1100°C or more, or more preferably 1200°C or more if copper is used, whereby it is melted. The heating process is performed in a stream of hydrogen.

Referring to Fig. 1D, the melted copper 11 permeates the gaps in the high-melting point metal layer 10a by a capillary phenomenon and completely fills the through-hole 2. Thus, a conductive portion 4a having electric conductivity and airtightness is formed.

The circuit board manufactured by the above-described steps has the conductive portions which tightly fill the through-holes 2. Those conductive portions ensure electric connection between circuits formed on the front and rear surfaces of the circuit board since the high-melting point metal or copper having good conductivity is used for those portions. In addition, since the through-holes 3 are tightly filled with those conductive portions, airtightness between the front and rear surfaces of the circuit board is sufficiently ensured.

Fig. 3 shows an example of integrated circuitry formed on a ceramic circuit board manufactured according to the present invention. Thin film circuits 24 are formed on front and rear surfaces of an AℓN board 1. Compact conductive portions 4a of tungsten (W) and copper (Cu) are formed in respective through-holes 2. The thin film circuit 24 formed on the front surface of the AℓN board 1 and the thin film circuit 24 formed on the rear surface thereof are electrically connected through the conductive portions 4a. The AℓN board is 1.0mm in thickness and the inner diameter of each through-hole 2 is 0.1mm. In the case of using a circuit board of such size, it would be impossible in a conventional method to maintain complete electric connection and airtightness. Accordingly, the circuits on both surfaces of the circuit board exhibit good characteristics in electric connection and airtightness.

Thus, according to the method of the present invention as specified in claim 1, after a high-melting point metal layer is formed in each through-hole in an insulating board, melted copper fills gaps or the like in the high-melting point metal layer to form conductive portions sealing the through-holes. Consequently, it is possible to realize a circuit board which maintains good electric connection and airtightness between front and rear surfaces of an insulating board.

Although the present invention has been described and illustrated in detail, it is clearly understood that the same is by way of illustration and example only and is not to be taken by way of limitation, the scope of the present invention being limited only by the terms of the appended claims.

## Claims

1. A method of manufacturing a ceramic circuit board including a conductive portion formed through an insulating board and electrically connecting circuits formed on front and rear surfaces of the insulating board, comprising the steps of:
- forming a through-hole (2) in a prescribed position of said insulating board (1),
- forming in said through-hole a high-melting point metal layer (10a) by putting high-melting point metal paste (10) into said through-hole and sintering said paste, thereby forming in said high-melting point metal layer a large number of gaps through dissipation of the solvent in the paste at the time of sintering,
- disposing a metal material containing copper in contact with said sintered paste on the side of said insulating board under said through-hole, and
- heating and melting said metal material containing copper under said through-hole in a stream of hydrogen so that said melted metal material permeates into said high-melting point metal layer through said gaps by a capillary phenomenon.

2. The method of manufacturing a ceramic circuit board in accordance with claim 1, wherein
said through-hole (2) is formed on the insulating board (1) not sintered,
said high-melting point metal layer (10a) is formed by putting high-melting point metal paste (10) into said through-hole and sintering said insulating board and said high-melting point metal paste at a high temperature.

3. The method of manufacturing a ceramic circuit board in accordance with claims 1, wherein
said through-hole (2) is formed on the insulating board (1) sintered, and
said high-melting point metal layer (10a) is formed by putting high-melting point metal paste (10) into said through-hole and sintering said paste.

## Patentansprüche

1. Verfahren zur Herstellung einer keramischen Schaltungsplatte einschließlich eines leitenden Teils, welcher durch eine isolierende Platte hindurch geformt ist und Schaltkreise elektrisch verbindet, welche an der Vorder- und Rückseite der isolierenden Platte gebildet sind, umfassend die Schritte:
- Bilden eines Durchgangsloches (2) an einer vorgeschriebenen Stelle der isolierenden Platte (1),
- Bilden einer Hochschmelzpunkt-Metallschicht (10a) in dem Durchgangsloch durch Eingeben einer Hochschmelzpunkt-Metallpaste (10) in das Durchgangsloch und Sintern der Paste, wodurch in der Hochschmelzpunkt-Metallschicht eine große Anzahl von Lücken durch Dissipation des Lösungsmittels in der Paste beim Sintern gebildet werden,
- Aufbringen eines Metallmaterials, welches Kupfer enthält, in Kontakt mit der gesinterten Paste auf der Seite der Isolierplatte unter dem Durchgangsloch, und
- Aufheizen und Schmelzen des Metallmaterials, welches Kupfer enthält, unter dem Durchgangsloch in einem Strom von Wasserstoff, sodaß das geschmolzene Metallmaterial in die Hochschmelzpunkt-Metallschicht durch die Lücken mittels der Kapillareffekts eindringt.

2. Verfahren zur Herstellung einer keramischen Schaltungsplatte nach Anspruch 1, worin
das Durchgangsloch (2) auf der nicht-gesinterten isolierenden Platte (1) gebildet ist, und
die Hochschmelzpunkt-Metallschicht (10a) gebildet wird durch Einbringen der Hochschmelzpunkt-Metallpaste (10) in das Durchgangsloch und Sintern der isolierenden Platte und der Hochschmelzpunkt-Metallpaste bei einer hohen Temperatur.

3. Verfahren zur Herstellung einer keramischen Schaltungsplatte nach Anspruch 1, worin
das Durchgangsloch (2) in der gesinterten isolierenden Platte (1) gebildet ist und
die Hochschmelzpunkt-Metallschicht (10a) gebildet wird durch Einbringen der Hochschmelzpunkt-Metallpaste (10) in das Durchgangsloch und Sintern der Paste.

## Revendications

1. Procédé pour la fabrication d'une plaquette de circuits imprimés en céramique comportant une portion conductrice formée à travers une plaquette isolante et connectant électriquement des circuits formés sur les surfaces avant et arrière de la plaquette isolante, comprenant les étapes consistant à :
- former un trou traversant (2) dans une position prescrite de la plaquette isolante (1),
- former dans ce trou traversant une couche métallique à point de fusion élevé (10a) en introduisant de la pâte métallique à point de fusion élevé (10) dans le trou traversant et en frittant cette pâte, formant ainsi dans cette couche métallique à point de fusion élevé un grand nombre d'espaces vides par dissipation du solvant dans la pâte lors du frittage,
- à mettre un matériau métallique contenant du cuivre en contact avec la pâte frittée sur le côté de la plaquette isolante sous le trou traversant, et
- faire chauffer et fusionner ce matériau métallique contenant le cuivre sous le trou traversant dans un courant d'hydrogène de façon que le matériau métallique en fusion pénètre dans la couche métallique à point de fusion élevé à travers ces espaces vides par effet de capillarité.

2. Procédé pour la fabrication d'une plaquette de circuits imprimés en céramique selon la revendication 1, dans lequel
le trou traversant (2) est formé sur la plaquette isolante (1) non frittée,
la couche métallique à point de fusion élevé (10a) est formée par l'introduction de la pâte métallique à point de fusion élevé (10) dans le trou traversant et frittage à une température élevée de la plaquette isolante et de la pâte métallique à point de fusion élevé.

3. Procédé pour la fabrication d'une plaquette de circuits imprimés en céramique selon la revendication 1, dans lequel
le trou traversant (2) est formé sur la plaquette isolante (1) frittée, et
la couche métallique à point de fusion élevé (10a) est formée par l'introduction de la pâte métallique à point de fusion élevé (10) dans le trou traversant et par frittage de cette pâte.
